## Europäisches Patentamt
## European Patent Office
## Office européen des brevets

(19)

(11) Publication number: **0 439 919 A1**

# EUROPEAN PATENT APPLICATION

(12)

(21) Application number: **90312881.7**

(22) Date of filing: **27.11.90**

(51) Int. Cl.5: **H01L 23/538**, H01L 23/14, H01L 23/64

(30) Priority: **05.01.90 GB 9000264**

(43) Date of publication of application:
**07.08.91 Bulletin 91/32**

(84) Designated Contracting States:
**DE FR GB IT NL**

(71) Applicant: **INTERNATIONAL COMPUTERS LIMITED**
**ICL House**
**Putney, London, SW15 1SW(GB)**

(72) Inventor: **Hamilton, Philip George Brereton**
**120 Sandbach Road, Road Heath**
**Stoke on Trent, Staffs ST7 3RN(GB)**

(74) Representative: **Guyatt, Derek Charles Patents and Licensing International Computers Limited et al**
**Six Hills House London Road**
**Stevenage, Herts, SG1 1YB(GB)**

(54) **Circuit packaging.**

(57) An improved packaging and interconnect arrangement for integrated circuit chips comprising a ceramic chip carrier (1,4-8) bonded to a resin-based high density interconnect system (11-15). The high dielectric constant of the ceramic ensures a high capacitance between power and ground planes within the chip carrier. The low dielectric constant of the resin-based interconnect system allows high speed signal transmission.

EP 0 439 919 A1

# CIRCUIT PACKAGING

The present invention relates to the packaging and interconnection of integrated circuit chips. Recent performance increases in semiconductor devices have not been realised in full due to inherent performance limitations produced by state-of-the-art packaging and interconnection techniques. Long signal paths, high network capacitance, high dielectric constant insulation coupled with free air input-output connections and long lead frames within the device package all diminish system performance.

The object of the present invention is to provide an improved packaging and interconnect arrangement for integrated circuit chips which overcomes these disadvantages.

According to one aspect of the invention a multichip integrated circuit assembly comprises:
a multichip carrier formed from a material having a high dielectric constant, the carrier including a voltage distribution plane and a ground plane; and
a high density interconnect system secured to the carrier and having conductive transmission lines carried on a material having a low dielectric constant.

According to another aspect of the invention a method of manufacturing a multichip integrated circuit assembly comprises the steps of:
forming a multichip carrier from a material having a high dielectric constant;
forming a high density interconnect system by supporting conductive transmission lines on a material having a low dielectric constant; and
bonding the interconnect system to the carrier so as to achieve electrical contact therebetween.

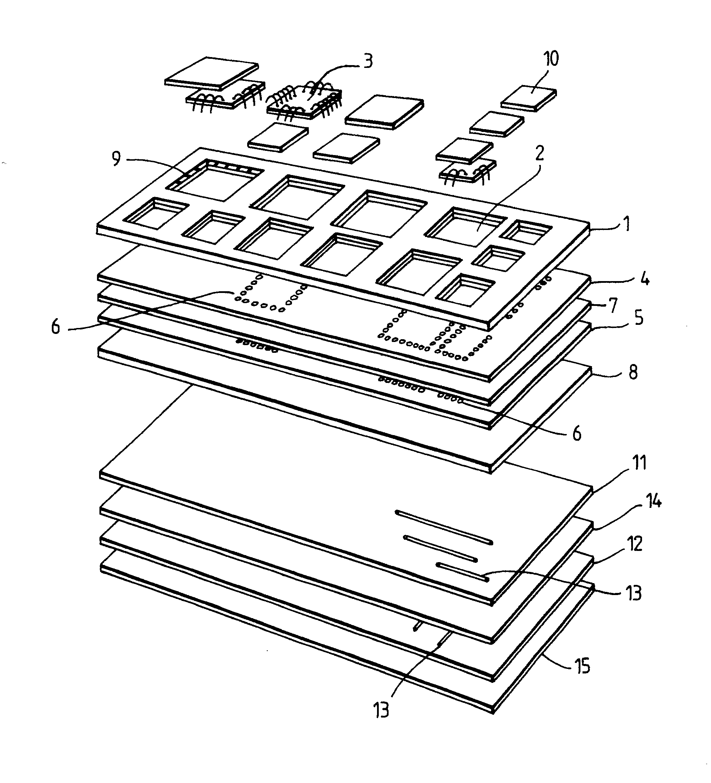

An embodiment of the invention will now be described, by way of example, with reference to the accompanying drawing which shows an exploded view of a multichip integrated circuit assembly.

Referring to the drawing, the upper part of the assembly, which forms the multichip carrier, is a structure comprising five layers. Layer 1 is a high dielectric constant ceramic layer containing cavities 2 which are arranged to receive integrated circuit chips 3. Layer 4 is a conductive ground distribution/screen plane and layer 5 is a similarly formed voltage distribution plane. The planes 4 and 5 each contain a pattern of apertures 6. The remaining two layers 7 and 8 are dielectric separators also of ceramic material having a high dielectric constant. Conductive pads 9 are provided around the inside edges of the cavities 2 to which the integrated circuit chips are electrically connected by a wire bonding technique.

Conductors (not shown) extend from the conductive pads 9 through the layers 4, 5, 7 and 8 terminating at further conductive pads (not shown) on the lower surface of the dielectric separator 8. The apertures 6 in the conductive planes 4 and 5 allow the conductors to pass through the planes without contact therewith. Further conductors (also not shown) extend from the ground and voltage planes 4 and 5 through the layers situated below these planes terminating at further pads on the lower surface of the dielectric separator 8.

The structure so far described may be manufactured by using a layered green tape alumina assembly which is subjected to a co-firing process. The manufacturing process will not be described in detail as the technique involved is well known in the art.

Sealing lids 10 are soldered to surface metallisation around the cavities 2 after the chips 3 have been inserted to hermetically seal the cavities.

The remainder of the assembly comprises a very high density, high speed interconnect system. Two resin based interconnect layers 11 and 12 each carry a series of parallel copper transmission lines 13, those on the layer 11 being orthogonally disposed with respect to those on the layer 12. The transmission lines 13 are 20 - 50 microns wide and 10 microns thick. An inner layer distribution plane 14 and an outer ground plane 15 are included in the interconnect system. Interconnect pillars (not shown) are formed within the transmission line width and pass through clearance holes (not shown) in the distribution plane 14 to form connections between selected transmission lines from the layers 11 and 12.

Although only two interconnect layers 11 and 12 have been described, more may be provided if required. For example, four interconnect layers could be dispersed in two pairs, each layer of a pair being separated by a ground and/or power plane. This arrangement would provide between 1000 and 3000 useable inches/per square inch of interconnect.

The interconnection system is bonded to the multichip carrier using, for example, an autoclave process. When bonded, electrical contact between the two is achieved by the conductive pads on the lower surface of the dielectric separator 8 contacting selected portions of the transmission lines 13 on the interconnect layer 11.

The described multichip assembly combines the advantages of a high dielectric constant ceramic chip carrier, ensuring a high level of coupling between the voltage and ground planes, with a very high density, low dielectric constant interconnect system thereby allowing high speed signal transmission.

In operation the inner layer distribution plane 14 provides, in conjunction with the adjacent outer ground plane 15 and the voltage distribution plane 6, a three plate impedance correction structure. The outer ground plane 15 is also effective to provide high speed logic tracking impedance correction and screening of the whole assembly.

## Claims

1. A multichip integrated circuit assembly comprising a multichip carrier including a voltage distribution plane and a ground plane, characterised in that a high density interconnect system (11-15) including conductive transmission lines (13) is secured to the carrier (1,4-8) and in that the carrier is made from a material (1,7,8) having a high dielectric constant and the conductive transmission lines (13) of the interconnect system are carried on a material (11,12) having a low dielectric constant.

2. An assembly as claimed in Claim 1 in which the multichip carrier is formed from a ceramic material.

3. An assembly as claimed in Claim 1 or 2, in which the conductive transmission lines (13) are carried on a resin-based material.

4. An assembly as claimed in any preceding claim in which the interconnect system includes a voltage distribution plane (14) and a ground plane (15), the voltage distribution plane forming, in conjunction with the ground plane and the voltage distribution plane (15) of the chip carrier, an impedance correction structure.

5. A method of manufacturing a multichip integrated circuit assembly comprising the steps of:
   forming a multichip carrier (1,4-8) from a material (1,7,8) having a high dielectric constant;
   forming a high density interconnect system (11-15) by supporting conductive transmission lines (13) on a material (11,12) having a low dielectric constant; and bonding the interconnect system to the carrier so as to achieve electrical contact therebetween.

6. A method as claimed in Claim 5 in which the multichip carrier (1,4-8) is formed from a ceramic material.

7. A method as claimed in Claim 5 or 6 in which the conductive transmission lines (13) are carried on a resin-based material.

European
Patent Office

EUROPEAN SEARCH
REPORT

Application Number

EP 90 31 2881

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 754 371 (NEC)<br>* Whole document *<br>— — — | 1-7 | H 01<br>L 23/538<br>H 01 L 23/14<br>H 01 L 23/64 |
| A | 39TH ECC '89, Houston, Texas, 22nd - 24th May 1989, IEEE 0569-5503/89/0629, pages 629-635; S. SASAKI et al.: "A new multi-chip module using a copper polyimide multi-layer substrate"<br>— — — — — | | |

TECHNICAL FIELDS
SEARCHED (Int. Cl.5)

H 01 L

The present search report has been drawn up for all claims

| Place of search | Date of completion of search | Examiner |
|---|---|---|
| The Hague | 13 May 91 | PROHASKA G.A.F. |